(19) Europäisches Patentamt

European Patent Office

Office européen des brevets

(11) **EP 0 602 370 B1**

(12) **EUROPÄISCHE PATENTSCHRIFT**

(45) Veröffentlichungstag und Bekanntmachung des Hinweises auf die Patenterteilung:
**09.02.2000 Patentblatt 2000/06**

(51) Int. Cl.$^7$: **H04B 1/10**, H03G 3/20

(21) Anmeldenummer: **93117867.7**

(22) Anmeldetag: **04.11.1993**

(54) **Rundfunkempfänger**

Broadcast receiver

Récepteur radio

(84) Benannte Vertragsstaaten:
**AT DE ES FR IT**

(30) Priorität: **09.12.1992 DE 4241362**

(43) Veröffentlichungstag der Anmeldung:
**22.06.1994 Patentblatt 1994/25**

(73) Patentinhaber:
**Blaupunkt-Werke GmbH
D-31139 Hildesheim (DE)**

(72) Erfinder:
• **Bartels, Stefan, Dr.
D-31139 Hildesheim (DE)**
• **Kässer, Jürgen, Dr.
D-31199 Diekholzen (DE)**
• **Chahabadi, Djahanyar Prof. Dr.-Ing.
D-23909 Ratzeburg (DE)**

(56) Entgegenhaltungen:
**US-A- 4 126 828          US-A- 4 654 884**

**Beschreibung**

Die Erfindung geht aus von einem Rundfunkempfänger nach der Gattung des Hauptanspruchs.

Durch Nichtlinearitäten auf dem Signalweg von zu empfangenden Signalen zwischen der Antenne und dem Mischer entstehen Mischprodukte aus Signalen, die nicht empfangen werden sollen. Mischprodukte, deren Frequenz innerhalb des Nutzfrequenzbereichs des jeweils eingestellten Senders liegen, treten als Intermodulation störend in Erscheinung.

Die Störwirkung ist umso größer, je stärker diejenigen Schaltungen ausgesteuert sind, welche die Nichtlinearitäten aufweisen. Die Störwirkung der Intermodulation kann dementsprechend durch Vermindern der Verstärkung der Eingangsschaltung herabgesetzt werden. Dazu ist es jedoch erforderlich zu erkennen, ob Intermodulation vorliegt.

Aufgabe der vorliegenden Erfindung ist es daher, einen Rundfunkempfänger anzugeben, bei welchem das Vorliegen von Intermodulation zuverlässig erkannt wird, so daß weitere Maßnahmen ergriffen werden können.

Aus der US-A-4 654 884 ist ein Funkempfänger bekannt, der über einen ersten Tuner, einen ersten Zwischenfrequenzverstärker, mindestens zwei zwischen Tuner und ZF-Verstärker angeordnete Filter unterschiedlicher Frequenzbänder und einen Umschalter verfügt, durch den das Ausgangssignal des ersten Tuners über eines der ZF-Filter dem ZF-Verstärker zuführbar ist. Weiter enthält der Funkempfänger eine AGC-(automatische Empfindlichkeitsanpassung) Schaltung, sowie eine erste PLL, durch die der erste Tuner auf eine gewünschte Empfangsfrequenz abstimmbar ist. Weiterhin umfaßt der Empfänger einen zweiten Empfangskreis mit zweitem Tuner, zweitem ZF-Verstärker und zweiter PLL zum Empfang einer vorgegebenen Empfangsfrequenz, sowie eine Empfangssignalpegelbestimmung, deren Ausgangssignal einer Steuerung zugeführt ist, die sowohl die Empfangsfrequenzen des ersten und des zweiten Tuners, als auch die Empfindlichkeit des ersten Empfangszweiges über die AGC-Schaltung beeinflußt. Der beschriebene Funkempfänger ist damit in der Lage, zur Vermeidung von durch Intermodulation verursachten Störungen im Empfangssignal die Empfangsempfindlichkeit mittels der AGC-Schaltung und die Durchlaßcharakteristik des ZF-Filters durch Auswahl des Filters mit der geeigneten Charakteristik automatisch einzustellen.

Der erfindungsgemäße Rundfunkempfänger hat den Vorteil, daß durch die Möglichkeit, störende Intermodulation zu erkennen, geeignete Maßnahmen zur Verminderung dieser Störung nur dann getroffen werden, wenn tatsächlich Intermodulation vorliegt. Bei bekannten Rundfunkempfängern mit einer automatischen Verstärkungsregelung wird Verstärkung bei hohen Eingangspegeln herabgesetzt, bei denen an sich Intermodulation auftreten kann. Dieses führt zu einer Desensibilisierung des Empfängers auch in denjenigen Fällen, in denen trotz hohem Empfangspegel keine Intermodulation auftritt.

Für die Wirkung der erfindungsgemäßen Maßnahmen ist es vorteilhaft, daß die Modulation des Empfangssignals mit dem Hilfssignal möglichst frühzeitig auf dem Weg des Empfangssignals erfolgt. Bei einer Weiterbildung der Erfindung ist deshalb vorgesehen, daß die Eingangsschaltung eine Vorselektionsstufe mit steuerbarem Dämpfungsgrad enthält und daß das Hilfssignal der Vorselektionsstufe zur Steuerung des Dämpfungsgrades zuführbar ist.

In besonders einfacher Weise kann die Modulation dadurch erfolgen, daß das Hilfssignal einer zur automatischen Verstärkungsregelung (AGC) dienenden Spannung überlagert wird. Dabei hat sich als günstig herausgestellt, wenn der Modulationsgrad 0,1 und die Frequenz des Hilfssignals 4kHz beträgt.

Der durch die erfindungsgemäßen Maßnahmen bedingte Mehraufwand kann dadurch gering gehalten werden, daß zum Vergleich der Amplituden das Zwischenfrequenzsignal zusätzlich zum ZF-Filter einem weiteren Filter zuführbar ist, dessen Durchlaßbereich ein Seitenband des Nutzfrequenzbereichs und ein durch die Modulation mit dem Hilfssignal entstandenes Seitenband umfaßt, und daß die Amplituden der Ausgangssignale beider Filter gemessen und durch einander dividiert werden.

Hierbei wird das ohnehin vorhandene ZF-Filter auch zur Erkennung der Intermodulation verwendet, so daß lediglich ein zusätzliches Filter und Einrichtungen zum Messen und Dividieren der Amplituden benötigt werden. Die Messung der Amplitude des Trägers wird zwar bei der Verwendung des Ausgangssignals des ZF-Filters durch die Seitenbänder innerhalb des Nutzfrequenzbereichs verfälscht. Dieses wird jedoch dadurch kompensiert, daß bei der Messung der Amplitude des Seitenbandes, das durch die Modulation mit dem Hilfsträger entstanden ist, ebenfalls ein Seitenband des Nutzfrequenzbereichs erfaßt wird.

Bei einer anderen Weiterbildung der Erfindung ist vorgesehen, daß für den empfangenen Träger und für mindestens eines der durch die Modulation mit dem Hilfssignal entstandenen Seitenbänder je ein schmalbandiges Filter vorgesehen ist und daß die Amplituden der Ausgangssignale der schmalbandigen Filter gemessen und durch einander dividiert werden.

Je nach Voraussetzungen im einzelnen kann der Mehraufwand bezüglich der Filter äußerst gering sein, wenn beispielsweise die Filter durch einen digitalen Signalprozessor gebildet werden.

Gemäß einer anderen Weiterbildung der Erfindung ist vorgesehen, daß außer einem Filter für den empfangenen Träger je ein Filter für das obere und das untere durch die Modulation mit dem Hilfssignal entstandene Seitenband vorgesehen ist und daß das Intermodulation bezeichnende Signal nur dann abgeleitet wird, wenn sowohl das Verhältnis zwischen den Amplituden des empfangenen Trägers und dem unteren Seitenband als auch das Verhältnis der Amplituden zwischen dem empfangenen Träger und dem oberen Seitenband von dem durch den Modulationsgrad gegebenen Verhältnis abweicht.

Diese Weiterbildung hat insbesondere den Vorteil, daß Störungen, die einseitig außerhalb des Nutzfrequenzbereichs auftreten, nicht als Intermodulation erkannt werden. Solche Störungen können beispielsweise von einem Sender in einem Nachbarkanal ausgehen, wenn dieser im Verhältnis zum empfangenen Sender mit relativ großer Feldstärke empfangen wird bzw. wenn dessen Seitenbänder im AM-Fall nicht vorschriftsmäßig auf ±4,5kHz begrenzt sind.

Durch die in weiteren Unteransprüchen aufgeführten Maßnahmen sind weitere vorteilhafte Weiterbildungen und Verbesserungen der im Hauptanspruch angegebenen Erfindung möglich.

Ausführungsbeispiele der Erfindung sind in der Zeichnung anhand mehrerer Figuren dargestellt und in der nachfolgenden Beschreibung näher erläutert. Es zeigt:

Fig. 1    ein Blockschaltbild eines Ausführungsbeispiels,

Fig. 2    Durchlaßkurven für bei dem Ausführungsbeispiel nach Fig. 1 verwendete Filter,

Fig. 3    Durchlaßkurven von Filtern bei einem zweiten Ausführungsbeispiel und

Fig. 4    Durchlaßkurven von Filtern bei einem dritten Ausführungsbeispiel.

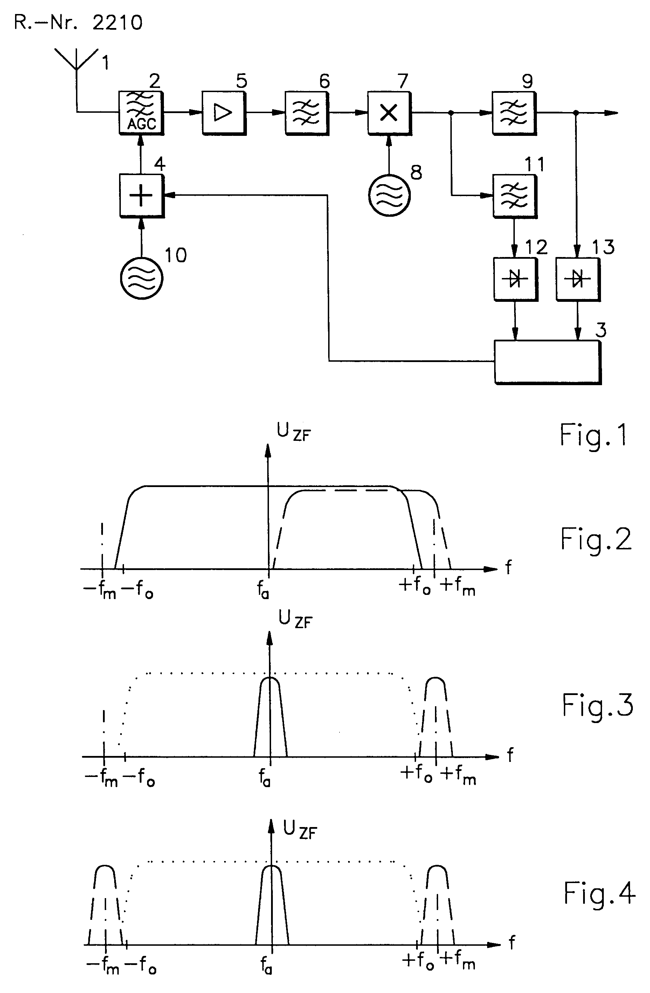

Fig. 1 stellt in Form eines Blockschaltbildes Teile eines Rundfunkempfängers dar, soweit sie zur Erläuterung der Erfindung erforderlich sind. Von einer Antenne 1 gelangen die zu empfangenden Signale zu einer Vorselektionsstufe 2, die einen Bandpaß mit steuerbarer Dämpfung enthält. Hierzu ist in an sich bekannter Weise eine pin-Diode vorgesehen, an die eine Steuerspannung - im folgenden AGC-Spannung genannt - zur Verstärkungsregelung angelegt wird. Diese wird von einer Steuereinheit 3 über eine Addierschaltung 4 der Vorselektionsstufe 2 zugeführt.

An die Vorselektionsstufe 2 schließt sich ein Vorverstärker 5 an, dessen Ausgangssignale über eine Zwischenselektionsstufe 6 einem Mischer 7 zugeführt werden. Dieser erhält außerdem die Ausgangsspannung eines Mischoszillators 8, so daß in an sich bekannter Weise am Ausgang des Mischers 7 ein ZF-Signal zur Verfügung steht, dessen Bandbreite durch ein anschließendes ZF-Filter 9 auf den Nutzfrequenzbereich begrenzt wird. Die Ausgangssignale des ZF-Filters können in an sich bekannter Weise verstärkt und demoduliert werden, was in Fig. 1 nicht dargestellt ist.

Die Durchlaßkurve des ZF-Filters 9 ist in Fig. 2 als durchgezogene Linie dargestellt und umfaßt einen Nutzfrequenzbereich, der bei einem AM-Empfänger etwa ±3,5kHz um die in den ZF-Bereich verschobene Trägerfrequenz bzw. Abstimmfrequenz $f_a$ beträgt. Die Grenzen des Nutzfrequenzbereichs sind mit $+f_o$ bzw. $-f_o$ bezeichnet.

Zum Erkennen einer etwaig vorhandenen Intermodulation wird bei dem Ausführungsbeispiel nach Fig. 1 ein von einem Oszillator 10 erzeugtes sinusförmiges Hilfssignal der AGC-Spannung in der Addierschaltung 4 überlagert und mit dieser dem Steuereingang der Vorselektionsstufe 2 zugeführt. Dadurch erfolgt eine Amplitudenmodulation der Empfangssignale. Diese hat im ZF-Signal zwei Seitenbänder zur Folge, die in den Figuren 2 bis 4 als strichpunktierte Linien mit den Frequenzen $+f_m$ und $-f_m$ dargestellt sind. Durch einen vorgegebenen Intermodulationsgrad weisen die Amplituden der Seitenbänder ein vorgegebenes Verhältnis zur Amplitude des Trägers auf.

Liegen jedoch zwei Sender, auf welche der Rundfunkempfänger nicht abgestimmt wurde, so im Frequenzbereich, daß ihr Intermodulationsprodukt bei der Abstimmfrequenz liegt (beispielsweise $2 \cdot f_1 - f_2 = f_a$), dann ist der Amplitudenunterschied zwischen dem Träger (bei $f_a$) und den zusätzlichen Seitenbändern (bei $f_a \pm f_m$) geringer als bei einem ohne Intermodulation empfangenen Sender. Wird nur ein Intermodulationsprodukt "empfangen", so ist bei einem Modulationsgrad von 0,1 der Amplitudenunterschied etwa 10dB geringer als bei einem Sender ohne Intermodulationstörungen.

Deshalb kann durch Filterung und Amplitudenvergleich festgestellt werden, ob es sich um einen tatsächlichen Nutzsender handelt oder um ein unerwünschtes Intermodulationprodukt.

Bei dem Ausführungsbeispiel nach Fig. 1 ist dazu ein zweites Filter 11 für das ZF-Signal vorgesehen, das die in Fig. 2 gestrichelt dargestellte Durchlaßkurve aufweist. Die Ausgangssignale des zusätzlichen Filters 11 und des ZF-Filters 9 werden je einer Amplitudenmeßeinrichtung 12, 13 zugeführt, die im wesentlichen aus je einem Amplitudendemodulator besteht, dessen Zeitkonstante größer als die tiefsten Modulationfrequenzen ist. Die somit ermittelten Amplitudenwerte werden der Steuereinheit 3 zugeführt, die beispielsweise aus einem Mikrocomputer mit einem geeigneten Programm gebildet wird, welches die zugeführten Signale durch einander dividiert und das somit berechnete Amplitudenverhältnis mit einem Sollwert bzw. Sollbereich vergleicht. Liegt das Verhältnis unter diesem Bereich, wird von der Steuereinheit 3 eine Verringerung der AGC-Spannung veranlaßt.

Bei dem Ausführungsbeispiel nach Fig. 1 wird nicht nur die Amplitude des Trägers, sondern des gesamten Nutzsignals gemessen. Die damit entstehende Verfälschung wird jedoch dadurch wieder ausgeglichen, daß anstelle des einzelnen Seitenbandes $+f_m$ bzw. $-f_m$ das vollständige Seitenband besichtigt wird, also einschließlich des Nutzseitenbandes. Dadurch kann das ohnehin vorhandene ZF-Filter 9 zur Ermittlung des Amplitudenverhältnisses mitverwendet werden, so daß lediglich ein zusätzliches Filter 11 erfoderlich ist.

Es ist jedoch im Rahmen der Erfindung ohne weiteres möglich, zur Ermittlung des Amplitudenverhältnisses zwei schmalbandige Filter zur Selektion des Trägers und eines der durch die zusätzliche Modulation entstandenen Seitenbänder zu verwenden, wie es in Fig. 3 dargestellt ist. Die durchgezogene Kurve stellt die Selektionskurve für den Träger, die gestrichelte Kurve diejenige für das Seitenband dar. Die Durchlaßkurve des ZF-Filters ist gepunktet wiedergegeben.

Es ist ferner im Rahmen der Erfindung möglich, drei schmalbandige Filter zur Selektion des Trägers und beider zusätzlicher Seitenbänder zu verwenden, wie es in Fig. 4 dargestellt ist. Dieses hat insbesondere den Vorteil, daß Störungen, die einseitig außerhalb des Nutzfrequenzbereichs auftreten, nicht als Intermodulation erkannt werden. Solche Störungen können beispielsweise von einem Sender in einem Nachbarkanal ausgehen, wenn dieser im Verhältnis zum empfangenen Sender mit relativ großer Feldstärke empfangen wird bzw. wenn dessen Seitenbänder nicht vorschriftsmäßig auf ±4,5kHz begrenzt sind.

**Patentansprüche**

1. Rundfunkempfänger mit einer Eingangsschaltung für über eine Antenne empfangene Signale, mit einem Mischer zur Ableitung eines ZF-Signals und mit einem ZF-Filter, dessen Durchlaßbereich einem Nutzfrequenzbereich des Empfangssignals entspricht,
dadurch gekennzeichnet,

daß zur Erkennung von Intermodulation die Empfangssignale mit einem in einem Oszillator (10) erzeugten Hilfssignal mit einem vorgegebenen Modulationsgrad amplitudenmoduliert werden, wobei außerhalb des Nutzfrequenzbereichs liegende Seitenbänder entstehen,
und daß Mittel (3) vorgesehen sind, mittels derer aus einem Vergleich der Amplituden mindestens eines durch die Modulation mit dem Hilfssignal entstandenen Seitenbandes und eines empfangenen Trägers in der ZF-Lage ein Signal abgeleitet wird, das bei Abweichungen von einem durch den Modulationsgrad bedingten Verhältnis eine Intermodulation anzeigt.

2. Rundfunkempfänger nach Anspruch 1, dadurch gekennzeichnet, daß die Eingangsschaltung eine Vorselektionsstufe (2) mit steuerbarem Dämpfungsgrad enthält und daß das Hilfssignal der Vorselektionsstufe (2) zur Steuerung des Dämpfungsgrades zuführbar ist.

3. Rundfunkempfänger nach einem der Ansprüche 1 oder 2, dadurch gekennzeichnet, daß das Hilfssignal einer zur automatischen Verstärkungsregelung (AGC) dienenden Spannung überlagert wird.

4. Rundfunkempfänger nach einem der Ansprüche 1 bis 3, dadurch gekennzeichnet, daß der Modulationsgrad 0,1 und die Frequenz des Hilfssignals 4kHz beträgt.

5. Rundfunkempfänger nach einem der vorhergehenden Ansprüche, dadurch gekennzeichnet, daß zum Vergleich der Amplituden das Zwischenfrequenzsignal zusätzlich zum ZF-Filter (9) einem weiteren Filter (11) zuführbar ist, dessen Durchlaßbereich ein Seitenband des Nutzfrequenzbereichs und ein durch die Modulation mit dem Hilfssignal entstandenes Seitenband umfaßt, und daß die Amplituden der Ausgangssignale beider Filter gemessen und durch einander dividiert werden.

6. Rundfunkempfänger nach einem der Ansprüche 1 bis 4, dadurch gekennzeichnet, daß für den empfangenen Träger und für mindestens eines der durch die Modulation mit dem Hilfssignal entstandenen Seitenbänder je ein schmalbandiges Filter vorgesehen ist und daß die Amplituden der Ausgangssignale der schmalbandigen Filter gemessen und durch einander dividiert werden.

7. Rundfunkempfänger nach Anspruch 6, dadurch gekennzeichnet, daß außer einem Filter für den empfangenen Träger je ein Filter für das obere und das untere durch die Modulation mit dem Hilfssignal entstandene Seitenband vorgesehen ist und daß das Intermodulation bezeichnende Signal nur dann abgeleitet wird, wenn sowohl das Verhältnis zwischen den Amplituden des empfangenen Trägers und dem unteren Seitenband als auch das Verhältnis der Amplituden zwischen dem empfangenen Träger und dem oberen Seitenband von dem durch den Modulationsgrad gegebenen Verhältnis abweicht.

8. Rundfunkempfänger nach einem der vorhergehenden Ansprüche, dadurch gekennzeichnet, daß das ZF-Filter und andere mit dem ZF-Signal beaufschlagte Filter mit einem digitalen Signalprozessor gebildet werden, mit dem ferner die Amplitudenmessungen und die Divisionen vorgenommen werden.

9. Rundfunkempfänger nach einem der vorhergehenden Ansprüche, dadurch gekennzeichnet, daß bei Vorhandensein von Intermodulation die Verstärkung einer Vorselektionsstufe herabgesetzt wird.

## Claims

**1.** Broadcast radio receiver having an input circuit for signals which are received via an antenna, having a mixer for deriving an IF signal and having an IF filter whose pass band corresponds to a wanted frequency band for the received signal, characterized

in that, in order to identify intermodulation, the received signals are amplitude-modulated with a predetermined modulation level by an auxiliary signal which is produced in an oscillator (10), as a result of which sidebands are produced which are outside the wanted frequency band,
and in that means (3) are provided using which a signal in the IF band is derived from a comparison of the amplitudes of at least one sideband, produced by the modulation with the auxiliary signal, and a received carrier, which signal indicates intermodulation if there are any discrepancies from a ratio caused by the modulation level.

**2.** Broadcast radio receiver according to Claim 1, characterized in that the input circuit includes a preselection stage (2) having a controllable attenuation level, and in that the auxiliary signal can be supplied to the preselection stage (2) in order to control the attenuation level.

**3.** Broadcast radio receiver according to one of Claims 1 or 2, characterized in that the auxiliary signal is superposed on a voltage which is used for automatic gain control (AGC).

**4.** Broadcast radio receiver according to one of Claims 1 to 3, characterized in that the modulation level is 0.1, and the frequency of the auxiliary signal is 4 kHz.

**5.** Broadcast radio receiver according to one of the preceding claims, characterized in that, for the comparison of the amplitudes, the intermediate-frequency signal can be supplied to a further filter (11) in addition to the IF filter (9), the pass band of which further filter (11) covers a sideband of the wanted frequency band and a sideband produced by the modulation with the auxiliary signal, and in that the amplitudes of the output signals from the two filters are measured and are divided by one another.

**6.** Broadcast radio receiver according to one of Claims 1 to 4, characterized in that a narrowband filter is provided in each case for the received carrier and for at least one of the sidebands produced by the modulation with the auxiliary signal, and in that the amplitudes of the output signals from the narrowband filters are measured and are divided by one another.

**7.** Broadcast radio receiver according to Claim 6, characterized in that, apart from a filter for the received carrier, a filter is in each case provided for the upper sideband and for the lower sideband which are produced by the modulation with the auxiliary signal, and in that the signal which indicates intermodulation is derived only when both the ratio between the amplitudes of the received carrier and the lower sideband and the ratio between the amplitudes of the received carrier and the upper sideband differ from the ratio given by the modulation level.

**8.** Broadcast radio receiver according to one of the preceding claims, characterized in that the IF filter and other filters to which the IF signal is applied are formed by a digital signal processor, using which, furthermore, the amplitude measurements and the divisions are carried out.

**9.** Broadcast radio receiver according to one of the preceding claims, characterized in that, if intermodulation is present, the gain of a preselection stage is reduced.

## Revendications

**1.** Récepteur radiophonique comportant un circuit d'entrée pour les signaux reçus par l'antenne, un mélangeur pour fournir un signal de fréquence intermédiaire FI et un filtre de fréquence intermédiaire FI dont la plage passante correspond à la plage des fréquences utiles du signal reçu, caractérisé en ce que

•  pour reconnaître l'intermodulation, on module en amplitude les signaux reçus avec un signal auxiliaire généré par un oscillateur (10) en appliquant un degré de modulation prédéterminé, pour former des bandes latérales situées à l'extérieur de la plage des fréquences utiles,
•  et des moyens (3) sont prévus qui permettent par comparaison des amplitudes d'au moins une bande latérale engendrée par la modulation, avec le signal auxiliaire et une porteuse reçue dans la zone FI, d'obtenir un signal qui indique, en cas de déviation d'un rapport résultant du degré de modulation, qu'il y a intermodulation.

**2.** Récepteur radiophonique selon la revendication 1,

caractérisé en ce que

le circuit d'entrée comporte un étage de présélection (2) avec un degré d'amortissement commandé, et le signal auxiliaire de l'étage de présélection (2) est appliqué comme signal de commande du degré d'amplification.

3. Récepteur radiophonique selon l'une des revendications 1 ou 2,
caractérisé en ce que

le signal auxiliaire est combiné à une tension assurant une régulation automatique de gain (commande automatique de gain AGC).

4. Récepteur radiophonique selon l'une des revendications 1 à 3,
caractérisé en ce qu'

on a un degré de modulation égal à 0,1 et la fréquence du signal auxiliaire est égale à 4 kHz.

5. Récepteur radiophonique selon l'une quelconque des revendications précédentes,
caractérisé en ce que

- pour comparer les amplitudes, on applique le signal de fréquence intermédiaire en plus d'un filtre FI (9) à un autre filtre (11) dont la plage passante correspond à une bande latérale de la plage des fréquences utiles et à une bande latérale engendrée par la modulation par le signal auxiliaire, et
- les amplitudes des signaux de sortie des deux filtres sont mesurées pour être divisées l'une par l'autre.

6. Récepteur radiophonique selon l'une quelconque des revendications 1 à 4,
caractérisé en ce que

pour la porteuse reçue et pour au moins l'une des bandes latérales générées par la modulation avec le signal auxiliaire, il y a chaque fois un filtre à bande étroite, et l'amplitude des signaux de sortie du filtre à bande étroite est mesurée, puis les deux amplitudes sont divisées l'une par l'autre.

7. Récepteur radiophonique selon la revendication 6,
caractérisé en ce qu'

- en dehors d'un filtre pour la porteuse reçue, on a chaque fois un filtre pour la bande latérale supérieure et la bande latérale inférieure générées par la modulation avec le signal auxiliaire, et

- le signal désignant l'intermodulation se déduit en ce que si à la fois le rapport entre les amplitudes de la porteuse reçue et la bande latérale inférieure, de même que le rapport entre les amplitudes de la porteuse reçue et la bande latérale supérieure, diffèrent du rapport donné par le degré de modulation.

8. Récepteur radiophonique selon l'une quelconque des revendications précédentes,
caractérisé en ce que

le filtre FI et d'autres filtres recevant le signal FI sont constitués par un processeur numérique de signal qui assure en outre les mesures d'amplitude et les divisions.

9. Récepteur radiophonique selon l'une quelconque des revendications précédentes,
caractérisé en ce qu'

en présence d'intermodulation, on diminue l'amplification de l'étage de présélection.

R.−Nr. 2210

Fig.1

Fig.2

Fig.3

Fig.4